# FASCICULE DE BREVET EUROPEEN

(11) **EP 3 333 880 B1**
(45) Date de publication et mention de la délivrance du brevet: **10.03.2021**
(21) Numéro de dépôt: 18152694.8
(22) Date de dépôt: 17.11.2015
(51) Int. Cl.: H01L 21/02, H01L 33/12, H01L 33/30, H01L 33/32, H01L 29/778

(54) **STRUCTURE SEMI-CONDUCTRICE À COUCHE DE SEMI-CONDUCTEUR DU GROUPE III-V COMPRENANT UNE STRUCTURE CRISTALLINE À MAILLES HEXAGONALES**
HALBLEITERSTRUKTUR MIT SCHICHT AUS HALBLEITERN DER GRUPPE III-V , DIE EINE KRISTALLINE STRUKTUR AUS HEXAGONALEN GITTERN UMFASST
SEMICONDUCTOR STRUCTURE WITH GROUP III-V SEMICONDUCTOR LAYER COMPRISING A CRYSTAL STRUCTURE WITH HEXAGONAL MESH

(30) Priorité: 18.11.2014 FR 1461109
(43) Date de publication de la demande: 13.06.2018
(62) Demande divisionnaire de: 15797989.9
(73) Titulaire: Commissariat à l'énergie atomique et aux énergies alternatives, 75015 Paris (FR)
(72) Inventeur: CHARLES, Matthew, 38000 GRENOBLE (FR)
(74) Mandataire: Brevalex

(56) Documents cités:
- EP-A2- 0 332 329
- US-A1- 2010 244 096
- US-A1- 2014 209 862
- US-A1- 2014 264 379

## Description

### DOMAINE TECHNIQUE ET ART ANTÉRIEUR

Il est décrit ici une structure semi-conductrice comportant une couche de semi-conducteur du groupe III-V de structure cristalline à mailles hexagonales et comprenant un paramètre de maille, ou paramètre cristallin, différent de celui du matériau du substrat sur lequel est formé cette couche, telle que définie par la revendication 1. Il est également décrit un ou plusieurs dispositifs semi-conducteurs réalisés à partir d'une telle structure semi-conductrice, comme par exemple des transistors tels que des transistors de type HEMT (« High Electron Mobility Transistor », ou transistor à haute mobilité électronique) ou des diodes électroluminescentes comprenant par exemple un ou plusieurs puits quantiques en semi-conducteur.

Parmi les différents semi-conducteurs existants, les semi-conducteurs du groupe III-V ou II-VI de structure cristalline à mailles cubiques ou hexagonales, et particulièrement le GaN, sont intéressants pour réaliser des dispositifs électroniques de grande qualité. Pour obtenir du GaN à un coût raisonnable, il est possible de réaliser une croissance de GaN par hétéro-épitaxie sur un substrat de nature différente tel qu'un substrat de silicium ou de saphir.

Ces matériaux tels que le silicium et le saphir comportent toutefois des paramètres de maille et des coefficients de dilatation thermique (« coefficient of thermal expansion» en anglais, ou CTE) différents de ceux du GaN. Ainsi, une croissance de GaN par épitaxie directement sur un substrat de silicium ou de saphir génère d'importants défauts cristallins dans le GaN tels que des dislocations.

Pour éviter l'apparition de ces défauts lors d'une croissance de GaN, il est nécessaire de faire croître au préalable sur le substrat une couche tampon sur laquelle le GaN est ensuite réalisé, cette couche tampon servant de couche de nucléation pour le GaN et permettant de modifier la contrainte dans le GaN. Une telle couche tampon correspond par exemple à une couche d'AlN permettant de réduire la différence entre le paramètre de maille du GaN et celui du matériau du substrat. Cependant, avec une simple couche tampon d'AlN, l'épaisseur de GaN de bonne qualité pouvant être obtenue est très limitée.

Pour réaliser une croissance d'une couche épaisse de GaN de bonne qualité sur du silicium, il est important que le GaN ne soit pas directement en contact avec le silicium et que le GaN soit formé avec une contrainte compressive de sorte que lors d'un refroidissement ultérieur à l'épitaxie du GaN, la couche de GaN ne se fissure pas à cause de la différence de CTE entre le GaN et le silicium. Etant donné que les dislocations dans les couches permettent une certaine relaxation, une diminution de la densité de dislocations dans la couche de GaN permet de la conserver en compression plus longtemps. De même, si des couches sont successivement réalisées par croissance et permettent de mettre le GaN en compression, cela provoque une remise à zéro des états de contrainte dans le GaN, et la plaque a alors une courbure nulle à température ambiante.

Le document US 2002/0074552 A1 décrit la réalisation d'une croissance de GaN sur un substrat de silicium via l'utilisation d'une structure tampon comprenant une première couche d'AlN et une couche d'AlGaN dont le taux de gallium augmente graduellement avec son épaisseur, de manière continue ou par paliers. Une telle couche tampon d'AlGaN dont la composition de gallium varie avec son épaisseur permet de mettre en compression le GaN. Toutefois, la réduction du nombre de dislocations dans le GaN formé sur une telle couche tampon reste insuffisante, et la tenue en tension pouvant être obtenue avec un tel matériau n'est pas suffisante non plus.

Il est également décrit dans le document US 2002/0074552 A1, ainsi que dans le document US 2012/0223328 A1, l'utilisation d'une structure tampon formée d'une alternance de couches d'AlGaN dont le taux de gallium est différent d'une couche à l'autre. Une telle structure tampon est appelée super-réseau (« superlattice » en anglais) Le document US 2010/244096 A1 décrit une autre structure tampon en super-réseau de l'art antérieur.

L'objectif de cette structure est de faire croître une couche relaxée avec un faible paramètre de maille (par exemple de l'AlN) sur une épaisseur de quelques nanomètres, puis de réaliser une couche en compression sur une épaisseur de plusieurs dizaines de nanomètres avec un paramètre de maille plus grand.

Un tel super-réseau permet d'obtenir une meilleure tenue en tension pour une couche résistive, mais ne permet pas de réduire suffisamment le taux de dislocations dans la couche finale de GaN.

Les problèmes exposés ci-dessus pour le GaN se retrouvent également lors de la croissance d'autres semi-conducteurs du groupe III-V et comprenant une structure cristalline à mailles hexagonales, sur un substrat dont le matériau présente un paramètre de maille différent de celui du semi-conducteur formé par croissance.

### EXPOSÉ DE L'INVENTION

Un but de la présente invention est de proposer une structure semi-conductrice telle que définie par la revendication 1.

Dans un exemple de mise en œuvre préféré décrit infra, la structure peut comporter un deuxième empilement.

Comme les super-réseaux de l'art antérieur, les premier et deuxième empilements d'une telle structure semi-conductrice comportent un grand nombre d'interfaces entre des couches de compositions différentes, ce qui permet de réduire la densité de dislocations se formant au sein de la structure. De plus, la valeur moyenne du paramètre de maille au sein des premier et deuxième empilements varie de manière croissante ou reste constante, ce qui permet de maintenir une bonne compression dans les matériaux comprenant une structure cristalline à mailles hexagonales.

Les premier et deuxième empilements des deuxièmes et troisièmes couches inclus dans cette structure semi-conductrice permettent d'avoir une première couche comportant, à épaisseur équivalente, une meilleure qualité que dans les structures de l'art antérieur, tout en conservant une bonne contrainte en compression au sein des différentes couches de la structure. De manière analogue, pour une qualité de semi-conducteur donnée (qualité du semi-conducteur de la première couche), cette structure permet d'avoir une première couche de semi-conducteur d'épaisseur supérieure à celle pouvant être obtenue avec les structures de l'art antérieur.

En outre, par rapport aux couches tampon de l'art antérieur utilisées et pour une même qualité du semi-conducteur final obtenu (semi-conducteur de la première couche), l'épaisseur totale des couches se trouvant entre le substrat et la première couche peut être inférieure à celles des couches tampon de l'art antérieur, pour les mêmes performances électriques, ce qui se traduit par un gain sur l'encombrement, et un coût de réalisation inférieur à ceux des structures de l'art antérieur. De plus, du fait qu'une augmentation de l'épaisseur totale des couches formées sur le substrat augmente la fragilité des plaques, cette réduction d'épaisseur permet d'améliorer la robustesse des plaques produites.

Le taux d'un élément du semi-conducteur des deuxièmes couches, c'est-à-dire le taux de gallium du semi-conducteur des deuxièmes couches dans le cas de l'invention, varie de manière croissante d'une deuxième couche à l'autre selon une direction allant du substrat à la première couche. Autrement dit, en considérant deux deuxièmes couches au sein du premier empilement, le taux de cet élément dans l'une de ces deux deuxièmes couches qui est la plus proche du substrat est inférieur au taux de cet élément dans l'autre de ces deux deuxièmes couches.

Lorsque la structure cristalline du semi-conducteur comprend des mailles hexagonales, comme c'est le cas de l'invention, le taux de cet élément du semi-conducteur des troisièmes couches est sensiblement constant dans toutes les troisièmes couches. Cette configuration permet l'ajout d'une contrainte compressive sans générer de dislocations car dans un tel semi-conducteur, il n'y a pas de plan de glissement, sauf parallèle à la croissance dans la direction <0001>. Cette contrainte compressive permet notamment de compenser la différence de CTE entre les matériaux, par exemple entre le GaN et le silicium, pendant le refroidissement après croissance.

Un semi-conducteur du groupe III-V correspond à un semi-conducteur comportant un ou plusieurs éléments appartenant à la colonne III A, ou 13, et un ou plusieurs éléments appartenant à la colonne V A, ou 15, du tableau périodique des éléments, ou table de Mendeleïev.

Un semi-conducteur du groupe II-VI correspond à un semi-conducteur comportant un ou plusieurs éléments appartenant à la colonne II B, ou 12, et un ou plusieurs éléments appartenant à la colonne VI A, ou 16, du tableau périodique des éléments.

L'épaisseur de chacune des deuxièmes et troisièmes couches est inférieure à une épaisseur critique au-delà de laquelle un phénomène de relaxation se produit et qui se traduit par la formation de dislocations et d'états d'interface. Cela est notamment vérifié en réalisant les deuxièmes et troisièmes couches avec une épaisseur inférieure à environ 2 nm. En évitant une telle relaxation dans les couches, un effet correspondant à une contrainte qui augmente de façon contrôlée et continue est obtenu.

En interposant plusieurs empilements, formant chacun un super-réseau, entre la première couche et le substrat, de nombreuses interfaces de différents matériaux sont interposées entre la première couche et le substrat, ce qui permet d'augmenter l'épaisseur totale de la structure semi-conductrice sans la fragiliser. Dans cette configuration, le deuxième empilement des deuxièmes et troisièmes couches de semi-conducteur disposé sur la quatrième couche de semi-conducteur permet d'appliquer une contrainte compressive sur cette quatrième couche de semi-conducteur et d'obtenir au final une structure plus épaisse munie à son sommet d'une première couche plus épaisse qui est par exemple compatible avec la réalisation d'un transistor apte à supporter des tensions électriques de valeurs plus importantes qu'une couche d'un même semi-conducteur mais plus fine. D'un point de vue électrique, cette configuration avec de très nombreuses interfaces permet donc d'améliorer la tenue en tension d'un dispositif électrique et/ou électronique réalisé à partir d'une telle structure semi-conductrice, tout en réduisant les fuites de courant au sein de cette structure.

De plus, la couche de relaxation d'AlN disposée entre la quatrième couche et le deuxième empilement permet de relaxer les contraintes sur le paramètre de maille entre la quatrième couche et de le deuxième empilement, facilitant ainsi la croissance du super-réseau correspondant au deuxième empilement sur la couche de relaxation, et réduisant encore plus les courants de fuite au sein de la structure en raison de l'amélioration de l'efficacité des interfaces.

Le deuxième empilement peut être similaire ou non au premier empilement.

La structure semi-conductrice peut être telle qu'elle comporte :
- n deuxièmes empilements de plusieurs deuxièmes et troisièmes couches disposées de manière alternée les unes sur les autres et comportant ledit semi-conducteur, disposés entre le premier empilement et la première couche,
- n quatrièmes couches de semi-conducteur de composition sensiblement similaire à celle du semi-conducteur de la première couche et telles que l'une des quatrièmes couches soit disposée sur et contre le premier empilement, et que la ou chacune des autres quatrièmes couches soit disposée sur et contre l'un des autres deuxièmes empilements,
- plusieurs couches de relaxation comprenant de l'AlN et chacune disposée entre l'une des quatrièmes couches et l'un des deuxièmes empilements,
avec n nombre entier compris entre 2 et 19.

En multipliant ainsi le nombre d'empilements, et donc de super-réseaux, au sein de la structure semi-conductrice, les courants de fuite au sein de la structure semi-conductrice sont réduits et cela permet d'augmenter la valeur de la tension de claquage d'un dispositif électrique/électronique qui comporte une telle structure semi-conductrice.

Les deuxièmes empilements peuvent être similaires ou non les uns des autres.

Le semi-conducteur est de l'Al_{X}Ga_{Y}In_{(1-X-Y})N, avec 0 ≤ X < 1, 0 < Y ≤ 1 et (X + Y) ≤ 1. Un tel semi-conducteur correspond à un semi-conducteur de type III-V comprenant une structure cristalline à mailles hexagonales.

La quatrième couche ou chacune des quatrièmes couches peut avoir une épaisseur comprise entre environ 0,5 et 1,5 fois l'épaisseur de l'empilement sur et contre lequel la quatrième couche est disposée.

Selon l'invention, le emi-conducteur de la première couche est du GaN, et le semi-conducteur des deuxièmes couches est de l'Al_{X}Ga_{(1-X)}N (ce qui correspond à de l'AlₓGa_{Y}In(_{1-X-Y})N avec X + Y = 1), et le semi-conducteur des troisièmes couches est du GaN.

Dans chacun des premier et deuxième(s) empilements, le semi-conducteur des deuxièmes couches peut être de l'Al_{X}Ga_{(1-X)}N tel que X varie d'environ 1 à environ 0,3 d'une deuxième couche à l'autre selon une direction allant du substrat à la première couche.

Dans un ou plusieurs des premier et deuxième empilements, des cinquièmes couches comprenant de l'AlN ou de l'AlGaN de composition différente de celle du semi-conducteur des deuxièmes et troisièmes couches peuvent être interposées entre des groupes de couches formés chacun d'une deuxième et d'une troisième couches. Ainsi, dans ce ou ces empilements, une telle cinquième couche d'AlN ou d'AlGaN peut être interposée entre deux groupes de couches formés chacun d'une deuxième et d'une troisième couches. Chacune des cinquièmes couches peut être disposée sur une troisième couche d'un de ces groupes de couches. Ces interfaces supplémentaires entre l'AlN ou l'AlGaN des cinquièmes couches et le semi-conducteur des troisièmes couches, par exemple en GaN, permettent de réduire encore plus les courants de fuite au sein des empilements.

La structure semi-conductrice peut comporter en outre une première couche tampon comprenant de l'AlN et disposée entre le substrat et le premier empilement.

Selon l'invention, l'épaisseur de chacune des deuxièmes et troisièmes couches est inférieure à environ 2 nm.

Les épaisseurs des deuxièmes couches peuvent être sensiblement similaires les unes par rapport aux autres et/ou les épaisseurs des troisièmes couches peuvent être sensiblement similaires les unes par rapport aux autres.

Le substrat peut comporter du silicium monocristallin.

L'épaisseur totale du premier empilement et/ou l'épaisseur totale du ou de chacun des deuxièmes empilements peut être inférieure ou égale à environ 5 µm.

La structure semi-conductrice peut comporter en outre au moins :
- un deuxième empilement de plusieurs deuxièmes et troisièmes couches disposées de manière alternée l'une contre l'autre et sensiblement similaires aux deuxièmes et troisièmes couches du premier empilement, disposé entre le premier empilement et la première couche,
- une quatrième couche de semi-conducteur de composition sensiblement similaire à la celle du semi-conducteur de la première couche et disposée entre les premier et deuxième empilements.

L'invention porte également sur un dispositif semi-conducteur tel que défini par la revendication 14, comportant au moins une structure semi-conductrice telle que définie ci-dessus et une zone, ou région, active comprenant la première couche de la structure semi-conductrice ou disposée sur la première couche de la structure semi-conductrice.

Ledit dispositif semi-conducteur peut comporter au moins une diode électroluminescente et/ou au moins un transistor comprenant la zone active.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une structure semi-conductrice selon un premier exemple de réalisation ;
- la figure 2 représente une variation du taux de gallium dans le semi-conducteur des couches de la structure semi-conductrice selon le premier exemple de réalisation ;
- la figure 3 représente une variation du taux de gallium dans le semi-conducteur des couches d'une structure semi-conductrice selon un deuxième exemple de réalisation ;
- la figure 4 représente une structure semi-conductrice, objet de la présente invention, selon un premier mode de réalisation ;
- la figure 5 représente schématiquement un transistor de puissance formé sur une structure semi-conductrice, objet de la présente invention, selon un mode de réalisation particulier;
- la figure 6 représente schématiquement une diode électroluminescente formée sur une structure semi-conductrice, objet de la présente invention, selon un mode de réalisation particulier;
- les figures 7 et 8 représentent des courants de fuite obtenus dans une structure semi-conductrice, objet de la présente invention ;
- la figure 9 représente une variation du taux de gallium dans le semi-conducteur des couches d'un empilement d'une structure semi-conductrice, objet de la présente invention, selon une variante avantageuse.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

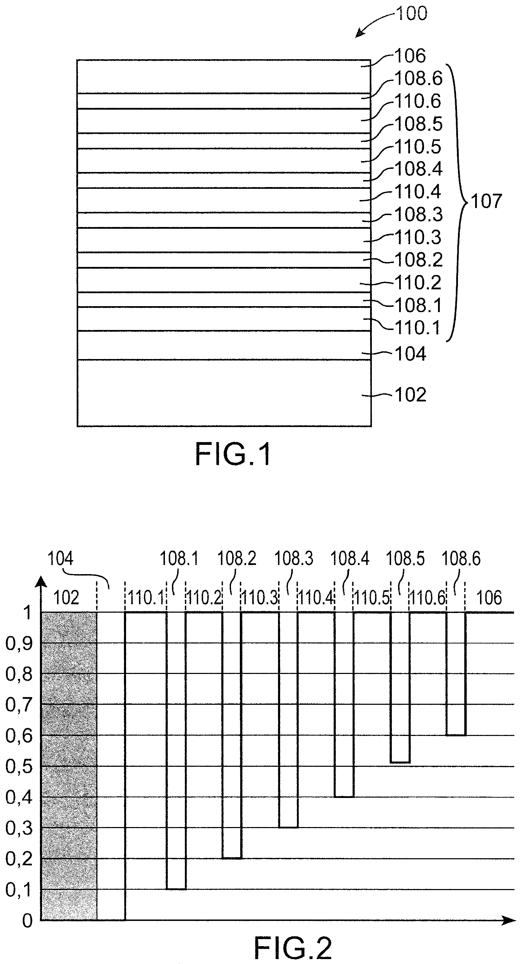

On se réfère tout d'abord à la figure 1 qui représente une structure semi-conductrice 100 selon un premier exemple de réalisation.

La structure 100 comporte un substrat 102 à partir duquel les autres couches de semi-conducteur de la structure 100 sont réalisées. Dans ce premier exemple de réalisation, le substrat 102 comporte du silicium monocristallin de type (111) dont l'épaisseur est de plusieurs microns ou plusieurs dizaines ou centaines de microns. En variante, le substrat 102 peut comporter d'autres matériaux comme par exemple du saphir ou du SiC.

Une couche tampon 104 est disposée sur le substrat 102 et sert de couche de nucléation pour la croissance des autres couches semi-conductrices de la structure 100. La couche tampon 104 comporte par exemple de l'AlN et une épaisseur pouvant être comprise entre environ 5 nm et 1 µm, par exemple égale à environ 200 nm. Cette couche tampon 104 a également pour rôle de protéger le substrat 102 vis-à-vis des températures élevées mises en jeu pour la réalisation des autres couches de semi-conducteur de la structure 100.

La structure 100 comporte également une première couche 106 de semi-conducteur disposée au sommet de la structure 100. Cette première couche 106 comporte le semi-conducteur destiné à servir à la réalisation de zones ou de régions actives de dispositifs semi-conducteurs. Le semi-conducteur de la première couche 106 correspond à un semi-conducteur du groupe III-V et qui comprend une structure cristalline à mailles hexagonales. Le semi-conducteur de la première couche 106 est du GaN qui est un semi-conducteur III-V de structure cristalline à mailles hexagonales. En variante ne faisant pas partie de l'invention, le semi-conducteur de la première couche 106 peut correspondre par exemple à de l'AlGaN ou de l'AlGaInN qui sont également des semi-conducteurs III-V de structures cristallines à mailles hexagonales. Selon une autre variante, la première couche 106 peut comporter un semi-conducteur III-V de structure cristalline à mailles cubiques, comme par exemple du GaAs ou de l'InP. Selon une autre variante ne faisant pas partie de l'invention, la première couche 106 peut comporter un semi-conducteur II-VI de structure cristalline à mailles hexagonales, comme par exemple du ZnO, ou de structure cristalline à mailles cubiques, comme par exemple du ZnS ou du ZnSe.

L'épaisseur de la première couche 106 est choisie en fonction de la future utilisation du semi-conducteur de cette couche 106. Ainsi, lorsque la première couche 106 est destinée à servir à la réalisation de zones actives de transistors de type HEMT et à supporter des tensions de plusieurs centaines de volts, l'épaisseur de la première couche 106 est par exemple égale à environ 2 µm. De manière générale, l'épaisseur de la première couche 106 peut être comprise entre environ 100 nm et 5 µm.

Du fait que le paramètre de maille du matériau du substrat 102 est différent de celui du semi-conducteur de la première couche 106, et pour pouvoir réaliser la première couche 106 telle que le semi-conducteur de cette couche soit de bonne qualité, suffisamment contraint en compression, avec une épaisseur suffisante et permette d'avoir une bonne tenue en tension, un empilement alterné de deuxièmes couches de semi-conducteur 108 et de troisièmes couches de semi-conducteur 110 est réalisé au préalable sur le substrat 102, la première couche 106 étant disposée sur cet empilement de couches 108, 110. Cet empilement porte la référence 107 sur la figure 1

L'épaisseur de chacune des couches 108, 110 est ici comprise entre environ 0,5 nm, c'est-à-dire environ l'épaisseur de deux monocouches, et 2 nm. Selon l'invention, l'épaisseur de chacune des couches 108, 110 est inférieure ou égale à environ 2 nm, voire inférieure ou égale à environ 1 nm. Les épaisseurs des deuxièmes couches 108 peuvent être similaires entre elles, comme c'est le cas sur la figure 1, ou être au moins en partie différentes les unes des autres. De même, les épaisseurs des troisièmes couches 110 peuvent être similaires entre elles, comme c'est le cas sur la figure 1, ou être différentes au moins en partie les unes des autres. Enfin, les épaisseurs des deuxièmes couches 108 peuvent être similaires ou différentes (cas de la figure 1) de celles des troisièmes couches 110. L'épaisseur de chacune des couches 108, 110 est inférieure à son épaisseur critique au-delà de laquelle se produit une relaxation pouvant se traduire par la formation de dislocations dans le matériau ou d'états d'interface aux interfaces avec les autres couches. Cette épaisseur critique dépend de la nature du semi-conducteur de ces couches. Par exemple, pour de l'AlN disposé sur du GaN, celui-ci commence à relaxer à partir d'une épaisseur égale à environ 2 nm.

Sur l'exemple de la figure 1, seules six deuxièmes couches 108, référencées 108.1 à 108.6, et six troisièmes couches 110, référencées 110.1 à 110.6, sont représentées. Toutefois, la structure 100 comporte généralement un nombre total de couches 108, 110 bien plus important que sur l'exemple de la figure 1, par exemple environ 500 ou plus généralement compris entre environ 150 et 2000. Le nombre total de couches 108, 110 de l'empilement 107 est notamment fonction des épaisseurs choisies pour ces couches ainsi que de l'épaisseur totale souhaitée pour cet empilement 107 de couches (qui dépend elle-même de l'épaisseur souhaitée pour la première couche 106) qui est généralement inférieure ou égale à environ 5 µm.

Dans ce premier exemple de réalisation, et selon l'invention, les troisièmes couches 110 comportent du GaN, et les deuxièmes couches 108 comportent de l'Al_{X}Ga_{(1-X)}N dont le taux de gallium (1-X) varie d'une deuxième couche 108 à l'autre. En effet, d'une couche 108 à l'autre, ce taux de gallium varie de manière croissante dans le sens allant du substrat 102 à la première couche 106. Ainsi la deuxième couche 108 qui est la plus proche du substrat 102 (la couche 108.1 sur l'exemple de la figure 1) peut avoir un taux de gallium proche de zéro, par exemple compris entre environ 0 et 0,2. La deuxième couche 108 qui est la plus proche de la première couche 106 (la couche 108.6 sur l'exemple de la figure 1) a, selon l'invention, un taux de gallium compris entre environ 0,6 et 0,1, et par exemple égal à 0,5. Selon l'invention, le taux de gallium des compositions moyennes des deux couches finales (couches 110.6 et 108.6 sur l'exemple de la figure 1) est choisi supérieur à environ 0,2 pour assurer la compression de la couche 106. De manière générale, en considérant deux deuxièmes couches 108 au sein de l'empilement 107, le taux de gallium dans l'une de ces deux deuxièmes couches 108 qui est la plus proche du substrat 102 est inférieur au taux de gallium dans l'autre de ces deux deuxièmes couches 108.

Dans le semi-conducteur des troisièmes couches 110, le taux de gallium est sensiblement constant (et ici égal à 1).

Du fait que le GaN des couches 106 et 110 correspond à de l'Al_{X}Ga_{Y}In_{(1-X-Y)}N, avec X = 0 et Y = 1, et que l'AlGaN des couches 108 correspond à de l'Al_{X}Ga_{Y}In_{(1-X-Y)}N, avec X + Y = 1, les couches 106, 108, 110 comportent bien chacune un semi-conducteur de nature similaire correspondant à de Al_{X}Ga_{Y}In_{(1-X-Y)}N, ce semi-conducteur étant de type III-V de structure cristalline à mailles hexagonales.

La figure 2 représente la variation du taux de gallium dans le semi-conducteur des différentes couches de la structure 100. Ce taux de gallium est nul dans le substrat 102 et dans la couche tampon 104, et est égal à 1 dans chacune des troisièmes couches 110 et dans la première couche 106. Dans la direction allant du substrat 102 à la première couche 106, le taux de gallium dans les deuxièmes couches 108 augmente régulièrement, couche après couche (augmentation de 0,1 par rapport à la deuxième couche précédente sur cet exemple). Ainsi, le paramètre de maille moyen de chaque groupe formé d'une des deuxièmes couches 108 et d'une des troisièmes couches 110 adjacentes l'une avec l'autre a une valeur variant de manière croissante depuis le substrat 102 jusqu'à la première couche 106. De plus, du fait que la composition du semi-conducteur des deuxièmes couches 108 varie d'une couche à l'autre, la contrainte change également le long de l'empilement 107 des couches 108, 110. La combinaison de ces caractéristiques de l'empilement 107 des couches 108 et 110 permet de réduire le nombre de dislocations apparaissant dans la première couche 106 tout en ayant un bon niveau de contrainte compressive dans cette couche 106, et cela pour une épaisseur relativement importante. Une bonne tenue en tension est également obtenue grâce à cette structure.

En variante de ce premier exemple de réalisation, il est possible que dans la direction allant du substrat 102 à la première couche 106, le taux de gallium dans les troisièmes couches 110 diminue régulièrement d'une troisième couche à l'autre. Cette diminution du taux de gallium d'une troisième couche 110 à l'autre est toutefois moins importante que l'augmentation du taux de gallium dans les deuxièmes couches 108 dans ce même sens afin que le paramètre de maille moyen de chaque groupe formé d'une des deuxièmes couches 108 et d'une des troisièmes couches 110 adjacentes l'une avec l'autre ait une valeur variant de manière croissante depuis le substrat 102 jusqu'à la première couche 106. Cette variation de la composition du matériau des troisièmes couches 110 contribue au changement de la contrainte le long de l'empilement des couches 108 et 110. Comme précédemment, la combinaison de ces caractéristiques de l'empilement 107 des couches 108 et 110 permet de réduire le nombre de dislocations apparaissant dans la première couche 106 tout en ayant un bon niveau de contrainte compressive dans cette couche 106, et cela pour une épaisseur relativement importante. Une bonne tenue en tension est aussi obtenue dans cette structure.

Dans les cas précédemment décrits, la variation de la composition des deuxièmes couches 108 et/ou la variation de la composition des troisièmes couches 110, et donc la variation du paramètre de maille moyen de chaque groupe formé d'une des deuxièmes couches 108 et d'une des troisièmes couches 110 adjacentes l'une de l'autre, peuvent être linéaires ou non.

Dans un deuxième exemple de réalisation ne faisant pas partie de l'invention, le semi-conducteur des couches 106, 108 et 110 peut correspondre à un semi-conducteur du groupe III-V ou II-VI qui comprend une structure cristalline à mailles cubiques. Un tel semi-conducteur est par exemple de l'Al_{X}Ga_{1-X}As. Dans ce cas, la couche tampon 104 comporte par exemple de l'AlAs ou du GaAs, la première couche 106 comporte du GaAs, et les deuxièmes et troisièmes couches 108 et 110 comportent de l'AlGaAs dans lesquelles le taux de gallium varie couche après couche aussi bien pour les deuxièmes couches 108 que pour les troisièmes couches 110. En effet, du fait que le semi-conducteur des couches 106, 108, 110 comporte une structure cristalline à mailles cubiques, l'empilement des couches 108 et 110 est réalisé tel que le taux de gallium varie au sein des couches 108 et 110 et tel que la valeur du paramètre de maille moyen de chaque groupe d'une deuxième et d'une troisième couches adjacentes soit sensiblement constante sur toute l'épaisseur de l'empilement des couches 108 et 110.

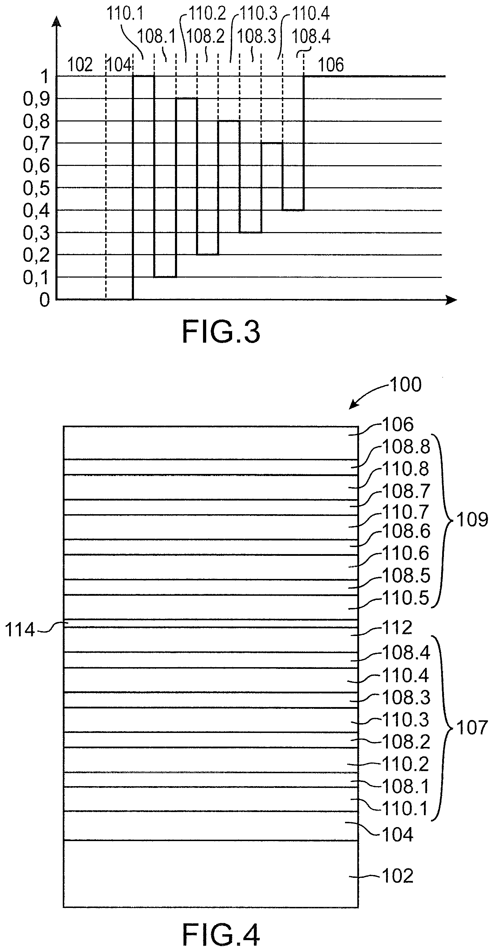

La figure 3 représente un exemple de variation du taux de gallium dans le semi-conducteur des différentes couches de la structure 100 selon ce deuxième exemple de réalisation, dans laquelle l'empilement de couches 108, 110 comporte quatre deuxièmes couches 108.1 à 108.4 et quatre troisièmes couches 110.1 à 110.4. On voit sur cette figure que dans la direction allant du substrat 102 à la première couche 106, le taux de gallium dans les deuxièmes couches 108 augmente régulièrement, couche après couche (pour chaque deuxième couche 108, augmentation de 0,1 par rapport à la deuxième couche 108 précédente sur cet exemple), et que parallèlement, dans cette même direction, le taux de gallium dans les troisièmes couches 110 diminue régulièrement et proportionnellement à l'augmentation du taux de gallium dans les deuxièmes couches 108 (pour chaque troisième couche 110, baisse de 0,1 par rapport à la troisième couche 110 précédente sur cet exemple). Ainsi, le paramètre de maille moyen de chaque groupe formé d'une des deuxièmes couches 108 et d'une des troisièmes couches 110 adjacentes l'une par rapport à l'autre a une valeur sensiblement constante depuis le substrat 102 jusqu'à la première couche 106. L'obtention d'un paramètre de maille moyen de chaque groupe formé d'une des deuxièmes couches 108 et d'une des troisièmes couches 110 adjacentes l'une par rapport à l'autre de valeur sensiblement constante depuis le substrat 108 jusqu'à la première couche 106, tout en ayant des couches 108 et 110 de compositions variables afin d'avoir un changement de la contrainte le long de l'empilement des couches 108 et 110, peut également être obtenu en réalisant les couches 108 et 110 telles que dans la direction allant du substrat 102 à la première couche 106, le taux de gallium dans les troisièmes couches 110 augmente régulièrement, couche après couche, et que parallèlement, dans cette même direction, le taux de gallium dans les deuxièmes couches 108 diminue régulièrement et proportionnellement à l'augmentation du taux de gallium dans les troisièmes couches 110.

Comme dans le premier exemple de réalisation, la variation de la composition des deuxièmes couches 108 et la variation de la composition des troisièmes couches 110 peuvent être linéaires ou non.

Selon un premier mode de réalisation, la structure 100 est telle qu'entre la première couche 106 et la couche tampon 104, plusieurs empilements de couches 108, 110, similaires aux empilements précédemment décrits, soient disposés les uns au-dessus des autres et séparés les uns des autres par des quatrièmes couches de semi-conducteur de composition similaire à celle du semi-conducteur la première couche 106.

La figure 4 représente une structure semi-conductrice 100 selon ce premier mode de réalisation. Ainsi, un premier empilement 107 de deuxièmes couches 108.1 à 108.4 et de troisièmes couches 110.1 à 110.4 d'AlGaN dont les compositions en gallium varient comme précédemment décrit en liaison avec la figure 2 (en ne considérant que les couches 110.1 à 110.4 et 108.1 à 108.4) est disposé sur la couche tampon 104. Une quatrième couche 112 de composition similaire à celle de la première couche 106 (ici en GaN) est disposée sur ce premier empilement 107. Une couche de relaxation 114 comprenant de l'AlN est disposée sur la quatrième couche 112. L'épaisseur de la couche de relaxation 114 est par exemple comprise entre environ 5 nm et 50 nm, par exemple égale à environ 15 nm. Un deuxième empilement 109 de deuxièmes couches 108.5 à 108.8 et de troisièmes couches 110.5 à 110.8, ici similaire au premier empilement 107, est disposé sur la couche de relaxation 114. La première couche 106 est formée sur ce deuxième empilement 109.

La répétition de l'empilement de couches 108, 110 au sein de la structure 100 permet d'appliquer une contrainte sur la quatrième couche 112 et d'obtenir ainsi une structure semi-conductrice 100 plus épaisse permettant la réalisation d'une première couche 106 d'épaisseur plus importante, par exemple pour la réalisation d'un dispositif semi-conducteur tel qu'un transistor pouvant supporter des tensions électriques de valeurs plus importantes qu'avec une structure ne comportant pas cette répétition d'empilements des deuxièmes et troisièmes couches 108, 110.

L'insertion de la couche de relaxation 114 entre la quatrième couche 112 et le deuxième empilement 109 permet de relaxer les contraintes sur le paramètre de maille entre la quatrième couche 112 et de le deuxième empilement 109, facilitant ainsi la croissance du deuxième empilement 109 sur la couche de relaxation, et réduisant encore plus les courants de fuite au sein de la structure 100.

De plus, comme précédemment, chaque empilement 107, 109 des couches 108, 110 comporte généralement un nombre de couches bien plus important que celles représentées sur la figure 4.

Sur la figure 4, deux empilements 107, 109 de couches 108, 110, séparés l'un de l'autre par la quatrième couche 112 et la couche de relaxation 114, sont disposés entre le substrat 102 et la première couche 106. Il est toutefois possible qu'un nombre plus important d'empilements de couches 108, 110, c'est-à-dire plusieurs deuxièmes empilements 109 disposés entre le premier empilement 107 et la première couche 106, et donc également plusieurs quatrièmes couches 112 et plusieurs couches de relaxation 114 chacune interposée entre deux deuxièmes empilements 109, soit superposés et disposés entre le substrat 102 et la première couche 106.

Dans tous les cas, le premier empilement 107 et les deuxièmes empilements 109 peuvent être similaires ou non les uns des autres, notamment en termes de nombre de deuxièmes et troisièmes couches 108, 110, épaisseur totale, taux de Ga dans les deuxièmes et troisièmes couches 108, 110, etc.

L'épaisseur de chaque quatrième couche 112 peut être comprise entre environ 0,5 et 1,5 fois l'épaisseur de l'empilement 107 ou 109 sur lequel repose la quatrième couche 112.

De manière avantageuse, la structure 100 peut comporter entre 1 et 19 deuxièmes empilements 109.

Quel que soit le mode de réalisation ou la variante de réalisation, les différentes couches de la structure semi-conductrice 100 sont réalisées par croissance, notamment par épitaxie par jet moléculaire ou par épitaxie en phase vapeur. Ces étapes de croissance peuvent être mises en œuvre à basse pression, par exemple à environ 75 mbar, à une température égale à environ 1000°C et sous une pression partielle d'ammoniac d'environ 10 mbar pour les couches 108, 110. Par exemple, pour une croissance de couches de nature similaire à celles du premier mode de réalisation précédemment décrit (à base de GaN), la croissance des couches peut être réalisée avec une pression comprise entre environ 25 mbar et 1000 mbar et une température comprise entre environ 900°C et 1100°C. Pour une croissance de couches de nature similaire à celles du deuxième exemple de réalisation (à base de GaAs), la croissance des couches peut être réalisée avec une pression comprise entre environ 25 mbar et 1000 mbar et une température comprise entre environ 500°C et 700°C.

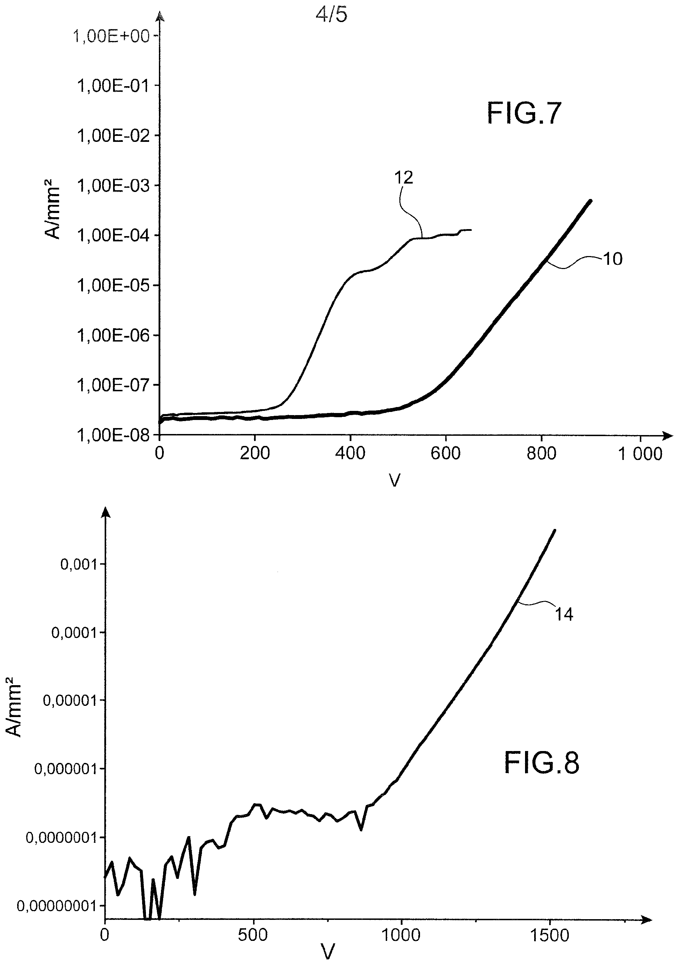

La courbe 10 représentée sur la figure 7 représente les courants de fuite obtenus jusqu'à la tension maximale de claquage dans une structure 100 telle que celle précédemment décrite en liaison avec la figure 4, comportant plusieurs empilements 107, 109 formés au total de 340 deuxièmes et troisièmes couches 108, 110, la structure 100 ayant une épaisseur totale d'environ 3,6 µm. A titre de comparaison, la courbe 12 représente les courants de fuite obtenus jusqu'à la tension maximale de claquage dans une structure d'épaisseur analogue mais ne comportant pas les empilements 107, 109.

Ces courbes montrent que l'ajout des empilements 107, 109 couplés à la ou aux quatrièmes couches 112 et à la ou aux couches de relaxation 114 permet d'obtenir une tension de claquage de valeur plus importante (gain de 250 V entre les courbes 10 et 12) et d'obtenir, pour une valeur de tension donnée, des courants de fuite plus faibles (par exemple gain d'un facteur 1000 à une tension de 600 V).

Sur la figure 8, la courbe 14 représente les courants de fuite obtenus dans une structure 100 telle que celle précédemment décrite en liaison avec la figure 4, mais comportant un premier empilement 107 et deux deuxièmes empilements 109 (avec trois quatrièmes couches 112 et deux couches de relaxation 114 disposées entre les empilements, l'épaisseur totale des couches interposées entre le substrat 102 et la première couche 106 étant d'environ 6,5 µm. On voit que la tension de claquage d'une telle structure 100 est supérieure à 1500 V et que des courants de fuite faibles, ici inférieurs à environ 5 µA/mm², sont obtenus pour des tensions inférieures à environ 1200 V.

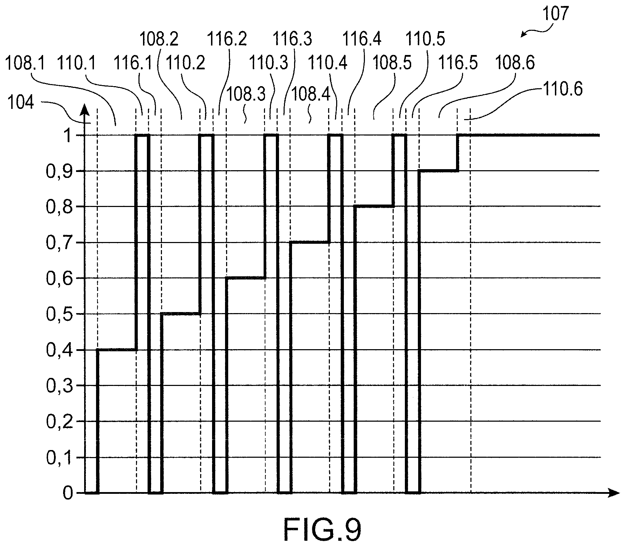

Dans une variante avantageuse, il est possible que dans un ou plusieurs des empilements 107, 109 de la structure 100, en plus des deuxièmes et troisièmes couches 108, 110, une cinquième couche 116 d'AlN ou d'AIGaN de composition différente de celle du semi-conducteur des deuxièmes et troisièmes couches 108, 110 soit insérée entre chaque groupe formé d'une deuxième couche 108 et d'une troisième couche 110. La figure 9 représente un exemple de variation du taux de gallium dans le semi-conducteur des différentes couches d'un des empilements d'une structure 100 selon cette variante avantageuse, par exemple ici le premier empilement 107. Dans ce premier empilement 107 formé sur la couche tampon 104, un premier groupe d'une deuxième couche 108.1 et d'une troisième couche 110.1 est formé sur la couche tampon 104. Une cinquième couche 116.1, comportant ici de l'AlN, est formée sur la troisième couche 110.1. Un deuxième groupe d'une deuxième couche 108.2 et d'une troisième couche 110.2 est formée sur la cinquième couche 116.1. Une autre cinquième couche 116.2, comportant également de l'AlN, est formée sur la troisième couche 110.2. Cette structure comportant un groupe d'une deuxième couche 108 et d'une troisième couche 110 et une cinquième couche 116 est répétée plusieurs fois pour former le premier empilement 107. Dans cet exemple, les six deuxièmes couches 108.1 à 108.6 ont un taux de gallium variant, d'une deuxième couche à l'autre, de 0,4 à 0,9.

En insérant ces cinquièmes couches 116 comportant de l'AlN ou de l'AlGaN au sein d'un ou plusieurs des empilements 107, 109, la croissance des matériaux des couches est facilitée. De plus, les interfaces formées entre les troisièmes couches 110 de GaN et les cinquièmes couches 116 d'AlN ou d'AlGaN permettent de réduire encore les courants de fuite dans ce ou ces empilements.

D'autres couches peuvent également être interposées au sein d'un ou plusieurs des empilements 107, 109, formant par exemple des structures de trois, quatre, cinq voire même six couches répétées pour former cet ou ces empilements pour faciliter la croissance des différentes couches de la structure 100, améliorer la tenue en tension et réduire les courants de fuite au sein de la structure 100.

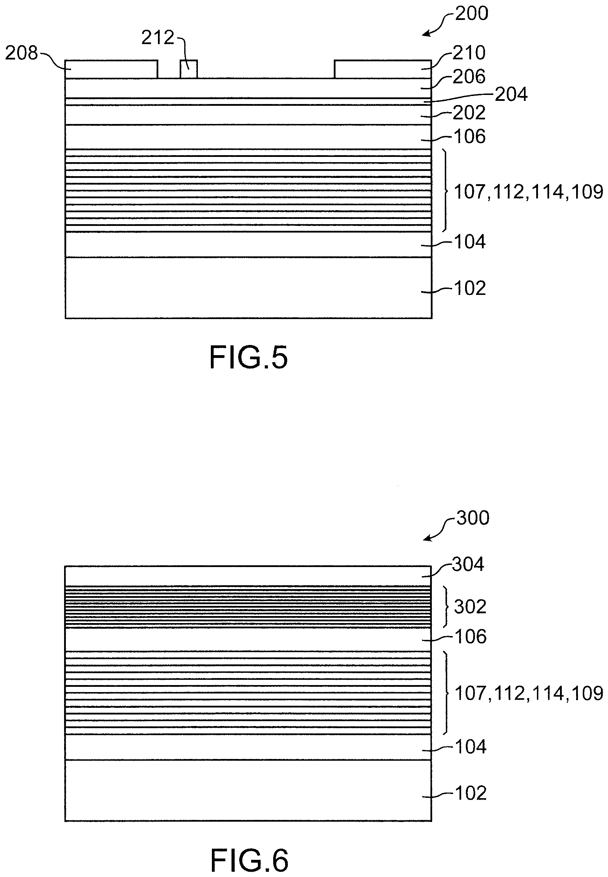

La première couche 106 obtenue peut être utilisée en tant que couche active de dispositifs semi-conducteurs réalisés à partir du substrat formé par la structure 100. Par exemple, un transistor HEMT 200 peut être réalisé à partir de la première couche 106 en GaN, comme représenté schématiquement sur la figure 5. Cette première couche 106 est dopée, par exemple avec du carbone et avec une concentration par exemple égale à environ 10¹⁹ cm⁻³. Une couche supplémentaire 202 comprenant un semi-conducteur similaire à celui de la première couche 106 et plus fine que la première couche 106 (épaisseur par exemple égale à environ 100 nm, ou comprise entre environ 25 nm et 1 µm), et comportant également du carbone en tant que dopant avec une concentration par exemple égale à environ 5.10¹⁶ cm⁻³, est formée sur la première couche 106. Cette couche supplémentaire 202 de GaN est destinée à former le canal du transistor HEMT 200. Une couche espaceur 204, comportant par exemple de l'AlN et d'épaisseur égale à environ 1 nm, est ensuite disposée sur la couche supplémentaire 202 de GaN.

Enfin, une couche d'AlGaN 206, comportant par exemple un taux de gallium égal à environ 80 % et permettant d'assurer la formation d'un gaz d'électrons bidimensionnel dans le canal du transistor 200, est formée sur cette couche espaceur 204. Le transistor HEMT 200 est ensuite achevé par des étapes classiques telles que la formation des régions de source 208 et de drain 210, des contacts métalliques, de la grille 212, etc.

La première couche 106 obtenue peut également être utilisée en tant que couche active d'une diode électroluminescente 300 comme représenté par exemple sur la figure 6. Dans ce cas, la première couche 106 de GaN peut être dopée n. Une structure à puits quantiques 302 comportant des couches barrières de GaN et des couches émissives d'InGaN est ensuite formée sur la première couche 106. Une couche 304 de GaN dopée p peut enfin être réalisée sur la structure à puits quantiques 302.

## Revendications

1. Structure semi-conductrice (100) comportant au moins :
- un substrat (102),
- une première couche (106) de GaN disposée sur le substrat (102),
- un empilement de plusieurs deuxièmes et troisièmes couches (108, 110) disposées de manière alternée l'une contre l'autre, entre le substrat (102) et la première couche (106), et tel que le semi-conducteur des deuxièmes couches (108) est de l'AlₓGa_{(1-X)}N avec 0 ≤ X < 1 et le semi-conducteur des troisièmes couches (110) est du GaN,
et dans laquelle :
- le matériau du substrat (102) comprend un paramètre de maille différent de celui du GaN,
- le taux de Ga du semi-conducteur des deuxièmes couches (108) varie de manière croissante d'une deuxième couche à l'autre selon une direction allant du substrat (102) à la première couche (106) et
- l'épaisseur de chacune des deuxièmes et troisièmes couches (108, 110) est inférieure à 2 nm
**caractérisée en ce que** :
- le taux de Ga du semi-conducteur de la deuxième couche (108) la plus proche de la première couche (106) est compris entre 0,6 et 0,1, et/ou le taux de Ga de la composition moyenne de l'ensemble formé de la deuxième couche (108) la plus proche de la première couche (106) et de la troisième couche (110) la plus proche de la première couche (106) est supérieur à 0,2 et
- les taux de Ga des semi-conducteurs au sein de chacune des deuxièmes couches (108) et des troisièmes couches (110) sont constants.

2. Structure semi-conductrice (100) selon la revendication 1, dans laquelle l'épaisseur de la première couche (106) est comprise entre 100 nm et 5 µm.

3. Structure semi-conductrice (100) selon l'une des revendications précédentes, dans laquelle le nombre total de deuxièmes et troisièmes couches (108, 110) est compris entre 150 et 2000.

4. Structures semi-conductrice (100) selon l'une des revendications précédentes, dans laquelle le taux de Ga du semi-conducteur de la deuxième couche (108) la plus proche du substrat (102) est compris entre 0 et 0,2.

5. Structure semi-conductrice (100) selon l'une des revendications précédentes, comportant en outre une couche tampon (104) comprenant de l'AIN et disposée entre le substrat (102) et l'empilement des deuxièmes et troisièmes couches (108, 110).

6. Structure semi-conductrice (100) selon la revendication 5, dans laquelle l'épaisseur de la couche tampon (104) est comprise entre 5 nm et 1 µm.

7. Structure semi-conductrice (100) selon l'une des revendications précédentes, dans laquelle les épaisseurs des deuxièmes couches (108) sont similaires les unes par rapport aux autres et/ou les épaisseurs des troisièmes couches (110) sont similaires les unes par rapport aux autres.

8. Structure semi-conductrice (100) selon l'une des revendications précédentes, dans laquelle le substrat (102) comporte du silicium monocristallin.

9. Structure semi-conductrice (100) selon l'une des revendications précédentes, dans laquelle l'épaisseur totale de l'empilement des deuxièmes et troisièmes couches (108, 110) est inférieure ou égale à 5 µm.

10. Structure semi-conductrice (100) selon l'une des revendications précédentes, comportant en outre une couche supplémentaire (202) de GaN et d'épaisseur inférieure à celle de la première couche (106), et telle que la première couche (106) soit disposée entre la couche supplémentaire (202) et l'empilement des deuxièmes et troisièmes couches (108, 110).

11. Structure semi-conductrice (100) selon la revendication 10, comportant en outre une couche espaceur (204) comprenant de l'AIN et disposée telle que la couche supplémentaire (202) soit disposée entre la couche espaceur (204) et la première couche (106).

12. Structure semi-conductrice (100) selon la revendication 11, comportant en outre une couche d'AIGaN (206) telle que la couche espaceur (204) soit disposée entre la couche d'AIGaN (206) et la couche supplémentaire (202).

13. Structure semi-conductrice (100) selon l'une des revendications 1 à 9, comportant en outre une couche (304) de GaN dopée p telle que la première couche (106) soit disposée entre la couche (304) de GaN dopée p et l'empilement des deuxièmes et troisièmes couches (108, 110).

14. Dispositif semi-conducteur (200, 300) comportant au moins une structure semi-conductrice (100) selon l'une des revendications 1 à 13 et une zone active comprenant la première couche (106) de la structure semi-conductrice (110) ou disposée sur la première couche (106) de la structure semi-conductrice (110).

15. Dispositif semi-conducteur (200, 300) selon la revendication 14, dans lequel ledit dispositif semi-conducteur comporte au moins une diode électroluminescente (300) et/ou au moins un transistor (200) comprenant la zone active.

## Patentansprüche

1. Halbleiterstruktur (100), zumindest enthaltend:
- ein Substrat (102),
- eine erste Schicht (106) aus GaN, die auf dem Substrat (102) angeordnet ist,
- eine Stapelung aus mehreren zweiten und dritten Schichten (108, 110), die abwechselnd aneinander zwischen dem Substrat (102) und der ersten Schicht (106) angeordnet sind, und zwar so, dass der Halbleiter der zweiten Schichten (108) Al_{X}Ga_{(1-X)}N mit 0 ≤ X < 1 ist und der Halbleiter der dritten Schichten (110) GaN ist,
wobei
- das Material des Substrats (102) eine Gitterkonstante aufweist, die sich von der von GaN unterscheidet,
- der Ga-Gehalt des Halbleiters der zweiten Schichten (108) von einer zweiten Schicht zur anderen in einer Richtung vom Substrat (102) zur ersten Schicht (106) hin zunehmend variiert,
- die Dicke der zweiten und der dritten Schichten (108, 110) jeweils weniger als 2 nm beträgt,
**dadurch gekennzeichnet, dass**
- der Ga-Gehalt des Halbleiters der zweiten Schicht (108), die der ersten Schicht (106) am nächsten liegt, zwischen 0,6 und 0,1 liegt, und/oder
- der Ga-Gehalt der durchschnittlichen Zusammensetzung der Anordnung, die aus der der ersten Schicht (106) am nächsten liegenden zweiten Schicht (108) und aus der der ersten Schicht (106) am nächsten liegenden dritten Schicht (110) gebildet ist, größer als 0,2 ist, und
- die Ga-Gehalte der Halbleiter innerhalb jeder der zweiten Schichten (108) und der dritten Schichten (110) konstant sind.

2. Halbleiterstruktur (100) nach Anspruch 1, wobei die Dicke der ersten Schicht (106) zwischen 100 nm und 5 µm liegt.

3. Halbleiterstruktur (100) nach einem der vorhergehenden Ansprüche, wobei die Gesamtanzahl der zweiten und dritten Schichten (108, 110) zwischen 150 und 2000 liegt.

4. Halbleiterstruktur (100) nach einem der vorhergehenden Ansprüche, wobei der Ga-Gehalt des Halbleiters der dem Substrat (102) am nächsten liegenden zweiten Schicht (108) zwischen 0 und 0,2 liegt.

5. Halbleiterstruktur (100) nach einem der vorhergehenden Ansprüche, ferner enthaltend eine Pufferschicht (104), die AlN enthält und zwischen dem Substrat (102) und der Stapelung aus zweiten und dritten Schichten (108, 110) angeordnet ist.

6. Halbleiterstruktur (100) nach Anspruch 5, wobei die Dicke der Pufferschicht (104) zwischen 5 nm und 1 µm liegt.

7. Halbleiterstruktur (100) nach einem der vorhergehenden Ansprüche, wobei die Dicken der zweiten Schichten (108) einander ähnlich sind und/oder die Dicken der dritten Schichten (110) einander ähnlich sind.

8. Halbleiterstruktur (100) nach einem der vorhergehenden Ansprüche, wobei das Substrat (102) monokristallines Silizium enthält.

9. Halbleiterstruktur (100) nach einem der vorhergehenden Ansprüche, wobei die Gesamtdicke der Stapelung aus zweiten und dritten Schichten (108, 110) kleiner oder gleich 5 µm ist.

10. Halbleiterstruktur (100) nach einem der vorhergehenden Ansprüche, ferner enthaltend eine zusätzliche Schicht (202) aus GaN mit einer geringeren Dicke als die der ersten Schicht (106), derart, dass die erste Schicht (106) zwischen der zusätzlichen Schicht (202) und der Stapelung aus zweiten und dritten Schichten (108, 110) angeordnet ist.

11. Halbleiterstruktur (100) nach Anspruch 10, ferner enthaltend eine Abstandshalterschicht (204), die AIN enthält und so angeordnet ist, dass die zusätzliche Schicht (202) zwischen der Abstandshalterschicht (204) und der ersten Schicht (106) angeordnet ist.

12. Halbleiterstruktur (100) nach Anspruch 11, ferner enthaltend eine AIGaN-Schicht (206), derart, dass die Abstandshalterschicht (204) zwischen der AlGaN-Schicht (206) und der zusätzlichen Schicht (202) angeordnet ist.

13. Halbleiterstruktur (100) nach einem der Ansprüche 1 bis 9, ferner enthaltend eine p-dotierte GaN-Schicht (304) derart, dass die erste Schicht (106) zwischen der p-dotierten GaN-Schicht (304) und der Stapelung aus zweiten und dritten Schichten (108, 110) angeordnet ist.

14. Halbleitervorrichtung (200, 300) mit zumindest einer Halbleiterstruktur (100) nach einem der Ansprüche 1 bis 13 und mit einem Wirkbereich, der die erste Schicht (106) der Halbleiterstruktur (110) enthält oder auf der ersten Schicht (106) der Halbleiterstruktur (110) angeordnet ist.

15. Halbleitervorrichtung (200, 300) nach Anspruch 14, wobei die Halbleitervorrichtung zumindest eine Leuchtdiode (300) und/oder zumindest einen Transistor (200) mit dem Wirkbereich enthält.

## Claims

1. Semiconductor structure (100) comprising at least:
- a substrate (102),
- a first layer (106) comprising GaN and arranged on the substrate (102),
- a stack composed of several second and third layers (108, 110) arranged alternately on each other, located between the substrate (102) and the first layer (106), and such that the semiconductor of the second layers (108) is Al_{X}Ga_{(1-X)}N with 0 ≤ X < 1 and the semiconductor of the third layers (110) is GaN,
and in which:
- the material of the substrate (102) comprises a lattice parameter different of that of GaN,
- the ratio of Ga of the semiconductor of the second layers (108) varies and increases from one second layer to the next along a direction from the substrate (102) to the first layer (106), and
- the thickness of each of the second and third layers (108, 110) is less than about 2 nm,
**characterized in that**:
- the ratio of Ga in the semiconductor of the second layer (108) which is closest to the first layer (106) is between about 0.6 and 0.1, and/or the ratio of Ga in the average composition of the set comprising the second layer (108) which is closest to the first layer (106) and the third layer (110) which is closest to the first layer (106) is higher than about 0.2, and
- the ratios of Ga in the semiconductors within each of the second layers (108) and of the third layers (110) are constant.

2. Semiconductor structure (100) according to claim 1, wherein the thickness of the first layer (106) is between about 100 nm and 5 µm.

3. Semiconductor structure (100) according to one of previous claims, wherein the total number of second and third layers (108, 110) is between about 150 and 2000.

4. Semiconductor structure (100) according to one of previous claims, wherein the ratio of Ga in the semiconductor of the second layer (108) that is closest to the substrate (102) is between about 0 and 0.2.

5. Semiconductor structure (100) according to one of the previous claims, also comprising a buffer layer (104) comprising AIN and located between the substrate (102) and the stack comprising the second and third layers (108, 110).

6. Semiconductor structure (100) according to claim 5, in which the thickness of the buffer layer (104) is between about 5 nm and 1 µm.

7. Semiconductor structure (100) according to one of the previous claims, in which the thicknesses of the second layers (108) are similar one to the other and/or the thicknesses of the third layers (110) are similar one to the other.

8. Semiconductor structure (100) according to one of the previous claims, in which the substrate (102) comprises monocrystalline silicon.

9. Semiconductor structure (100) according to one of the previous claims, in which the total thickness of the stack comprising the second and third layers (108, 110) is less than or equal to about 5 µm.

10. Semiconductor structure (100) according to one of the previous claims, further comprising an additional layer (202) including GaN and having a thickness lower than that of the first layer (106), and such that the first layer (106) is arranged between the additional layer (202) and the stack comprising the second and third layers (108,110).

11. Semiconductor structure (100) according to claim 10, further comprising a spacer layer (204) comprising AIN and arranged such that the additional layer (202) is arranged between the spacer layer (204) and the first layer (106).

12. Semiconductor structure (100) according to claim 11, further comprising an AIGaN layer (206) such that the spacer layer (204) is arranged between the AIGaN layer (206) and the additional layer (202).

13. Semiconductor structure (100) according to one of claims 1 to 9, further comprising a p doped GaN layer (304) such that the first layer (106) is arranged between the p doped GaN layer (304) and the stack comprising the second and third layers (108, 110).

14. Semiconductor device (200, 300) comprising at least one semiconductor structure (100) according to one of claims 1 to 13 and an active zone comprising the first layer (106) of the semiconductor structure (110) or located on the first layer (106) of the semiconductor structure (100).

15. Semiconductor device (200, 300) according to claim 14, in which said semiconductor device comprises at least one light emitting diode (300) and/or at least one transistor (200) including the active zone.
